# EUROPÄISCHE PATENTSCHRIFT

(11) **EP 2 364 234 B1**
(45) Veröffentlichungstag und Bekanntmachung des Hinweises auf die Patenterteilung: **06.09.2017**
(21) Anmeldenummer: 09771660.9
(22) Anmeldetag: 01.12.2009
(51) Int. Cl.: B23K 11/25, H01F 38/08

(54) **VERFAHREN UND VORRICHTUNG ZUM ERMITTELN EINES GLEICHSTROMS UND WIDERSTANDSSCHWEIßVORRICHTUNG**
DEVICE AND METHOD FOR MEASURING A DIRECT CURRENT AND RESISTANCE WELDING DEVICE
PROCÉDÉ ET DISPOSITIF DE MESURE DE COURANT CONTINU AINSI QUE DISPOSITIF DE SOUDAGE PAR RÉSISTANCE

(30) Priorität: 09.12.2008 AT 19152008
(43) Veröffentlichungstag der Anmeldung: 14.09.2011
(73) Patentinhaber: Fronius International GmbH, 4643 Pettenbach (AT)
(72) Erfinder: BADEGRUBER, Thomas, 4650 Lambach (AT); ENNSBRUNNER, Helmut, 4060 Leonding (AT)
(74) Vertreter: Sonn & Partner Patentanwälte
(86) Internationale Anmeldenummer: PCT/AT2009/000465
(87) Internationale Veröffentlichungsnummer: WO 2010/065975

(56) Entgegenhaltungen:
- EP-A2- 1 249 298
- DE-A1- 2 656 817
- GB-A- 2 321 539
- US-A- 5 196 668

## Beschreibung

Die Erfindung betrifft ein Verfahren zum Ermitteln eines in einem Leiter fließenden Gleichstroms mit einer Amplitude größer 500 A, welcher Gleichstrom durch mehrere, in Einzelleitern mit Schaltelementen fließende, zeitabhängige Teilströme zusammengesetzt wird.

Weiters betrifft die vorliegende Erfindung eine Vorrichtung zum Ermitteln eines in einem Leiter fließenden Gleichstroms mit einer Amplitude größer 500 A, welcher Gleichstrom durch mehrere, in Einzelleitern mit Schaltelementen fließende, zeitabhängige Teilströme zusammengesetzt ist.

Die gegenständliche Erfindung bezieht sich auf die Ermittlung von Gleichströmen hoher Amplitude, wie sie beispielsweise bei Widerstandsschweißvorrichtungen oder auch Batterieladegeräten auftreten. Die Messung des Gleichstroms ist für die Regelung des Schweißverfahrens oder Regelung des Ladeverfahrens und zur Gewährleistung einer gleichbleibenden Schweißqualität bzw. eines optimalen Ladeverfahrens essentiell. Unter den Begriff Gleichstrom fallen auch zeitabhängige Ströme verschiedenen Verlaufs, deren Mittelwert ungleich Null ist.

Die Messung von Gleichströmen mit einer Amplitude größer 500 A, wie sie beispielsweise bei Widerstandsschweißverfahren auftreten, kann mittels Shuntwiderständen vorgenommen werden. Derartige Shuntwiderstände für hohe Ströme sind extrem schwer und müssen hochpräzise Werte aufweisen. Zusätzlich ist zur Vermeidung einer Temperaturabhängigkeit eine entsprechende Temperaturkompensation erforderlich. Aufgrund des damit verbundenen hohen Aufwandes eignen sich derartige Strommessverfahren für Gleichströme mit einer Amplitude größer 500 A für einen Serieneinsatz im Allgemeinen nicht.

Auch klassische Stromwandler erfordern einen relativ hohen Platzbedarf, weshalb sie zwar für Kalibrierungen verwendet werden können, für permanente Messungen eines Gleichstroms im Serieneinsatz jedoch nicht praktikabel sind.

Eine Verbesserung kann dadurch erzielt werden, dass der Gleichstrom indirekt über die in einer Spule induzierte Spannung erfasst wird. Zu diesem Zweck wird eine sogenannte Rogowski-Spule um den stromführenden Leiter angeordnet, so dass der durch den Leiter fließende Strom ein Magnetfeld erzeugt, welches in der Rogowski-Spule eine Spannung induziert. Um auf den Leiterstrom rückschließen zu können, muss das Zeitintegral der induzierten Spannung gebildet werden. Auf diese Weise erhält man eine dem gemessenen Strom proportionale Spannung. Gegenüber herkömmlichen Stromwandlern sind Rogowski-Spulen aufgrund des fehlenden Eisenkerns wesentlich kleiner aufgebaut. Darüberhinaus entfallen nichtlineare Einflüsse des Eisenkerns. Hierbei wird die Rogowski-Spule im gemeinsamen Leiter beispielsweise zur Widerstandsschweißzange angeordnet, um in einem Messverfahren die Summe aller Teilströme des Transformators zu messen.

Die bei der Rogowski-Strommessung erforderlichen Integratoren beeinflussen jedoch die Genauigkeit des Messergebnisses negativ, da deren Übertragungsfunktion nicht BIBO-stabil (Bounded-Input Bounded-Output stabil) ist und somit mit zunehmender Messdauer zu einem Abdriften des Messsignals führt. Dieses Abdriften ist bei der Messung von niederfrequenten Strömen - speziell von Gleichströmen - nicht vom Messsignal unterscheidbar. Bei Widerstandsschweißvorrichtungen kann es bei langen Schweißzeiten von beispielsweise ein bis einigen Sekunden zu einer unzulässigen Drift des Messsignals, welches proportional zum Schweißstrom ist, kommen. Beispielsweise können dadurch statt 10 kA für den Schweißstrom nur 8 kA am Ende der Schweißung gemessen werden. Aufgrund der falschen Messwerte kann es wiederum zu Qualitätseinbußen bei den Schweißpunkten kommen, da der Schweißstrom derart geregelt wird, dass der Ist-Wert, welcher fehlerbehaftet ist, gleich dem Soll-Wert ist.

Daher gilt es diese Drift des Schweißstroms durch die Integratoren unbedingt zumindest zu verringern oder zu vermeiden.

Beispielsweise beschreibt die DE 26 56 817 A1 einen Strommessgeber für die potentialtrennende Erfassung des Strom-Istwertes in einem Leiter unter Verwendung einer Rogowski-Spule, wobei der Integrator kurzgeschlossen bzw. rückgesetzt wird, wenn der zu messende getaktete Gleichstrom Null geworden ist. Abgesehen davon, dass sich dieses Dokument nicht auf die Messung besonders hoher Ströme (größer 500 A) bezieht, kann ein Rücksetzen des Integrators nur dann erfolgen, wenn der Strom im Leiter Null ist. Das heißt also, dass die Rücksetzung beispielsweise vor oder nach einer Schweißung erfolgt.

Für die Messung von Gleichströmen während eines Stromflusses, wie sie bei Widerstandsschweißvorrichtungen, Batterieladegeräten, usw. auftreten und welche im Allgemeinen während einer Schweißung, eines Ladevorgangs, usw. nicht Null werden, eignet sich das Prinzip daher nicht. Denn damit könnte keine Qualitätssicherung durchgeführt werden.

Bei Widerstandsschweißvorrichtungen ist es allgemein Stand der Technik, dass der für eine Schweißung erforderliche Gleichstrom mit einer Rogowski-Spule gemessen wird. Hierbei ist von Nachteil, dass der dazu erforderliche Integrator lediglich vor einer Schweißung rückgesetzt werden kann. Somit sind äußerst aufwendige Integratorschaltungen erforderlich, welche über die Zeit der Schweißung so wenig Drift wie möglich verursachen. Tritt ein Abdriften eines Integrators zur Schweißstrommessung auf, dann wird oft die Soll-Wert-Vorgabe der Parameter für eine Schweißung angepasst, um die geforderte Qualität der Schweißpunkte in der Anlage zu erhalten.

Dies hat den Nachteil zur Folge, dass diese Parameter nicht eins zu eins auf eine gleichwertige Widerstandsschweißvorrichtung übertragen werden können, da das Integratorverhalten zumindest aufgrund von Bauteilschwankungen unterschiedlich ist. Zu berücksichtigen ist im Allgemeinen auch, dass für eine Widerstandsschweißvorrichtung zumindest ein Schweißtransformator mit integrierter Gleichrichtereinheit (Stromquelle) und ein Umrichter mit Stromregelung erforderlich sind. Im Schweißtransformator wird auch die Rogowski-Spule integriert, wobei der Integrator Teil des Umrichters ist. Auch werden der Schweißtransformator und der Umrichter nicht notwendigerweise von einem Hersteller gefertigt. Das heißt, dass der Schweißtrafo so ausgelegt ist, dass dieser mit allen Umrichtern unterschiedlicher Hersteller eingesetzt werden kann. Dies ist auch durch entsprechende Normen und Merkblätter geregelt.

Beispielsweise beschreibt die JP 61-271466 A eine solche Widerstandsschweißanlage, bei welcher eine durch den primärseitigen Strom induzierte Spannung erfasst und ausgewertet wird. Zur Reduktion der Drift der Messwerte wären sehr hohe Anforderungen an die Integratorschaltung erforderlich.

Ein Verfahren zum Ermitteln eines Gleichstroms bei einer Widerstandsschweißvorrichtung ist beispielsweise auch aus der GB 2 321 539 A bekannt geworden.

Die Anwendung von Rogowski-Spulen zur Strommessung wird beispielsweise in der EP 1 249 298 A2, der DE 26 56 817 A1 und der US 5 196 668 A beschrieben.

Das Ziel und die damit verbundene Aufgabe der vorliegenden Erfindung ist daher die Schaffung eines Verfahrens und einer Vorrichtung, durch welche der Gleichstrom mit einer Amplitude größer 500 A möglichst genau ermittelt werden kann. Das Verfahren bzw. die Vorrichtungen sollen möglichst einfach und kostengünstig durchführbar bzw. aufgebaut sein. Nachteile bekannter Verfahren und Vorrichtungen sollen vermieden oder zumindest reduziert werden.

Gelöst wird die erfindungsgemäße Aufgabe durch ein oben genanntes Verfahren, bei dem zumindest eine induzierte Teilspannung durch den zumindest in einem Einzelleiter fließenden Teilstrom durch Anordnung zumindest einer Rogowski-Spule um zumindest einen Einzelleiter erzeugt wird, wobei der Einzelleiter durch einen Pfad eines Gleichrichters auf einer Sekundärseite eines Transformators mit Mittelanzapfung gebildet wird, und diese induzierte Teilspannung in zumindest einem Integrator integriert und mit einer mit dem zumindest einen Integrator verbundenen Auswerteeinheit der Gleichstrom ermittelt wird. Erfindungsgemäß wird also die Rogowski-Spule nicht wie bei Widerstandsschweißanlagen üblich im Strompfad des zu messenden Gleichstroms (wie beispielsweise ein Gleichstrom für eine Widerstandsschweißung) platziert, sondern in einem Einzelleiter, welcher einen Teilstrom des zu messenden Gleichstroms führt. Dadurch kann aufgrund der Teilströme der Gleichstrom ermittelt werden. Wesentlich bei der Anordnung in den Teilstrombereichen ist, dass dieser Teilstrom die Eigenschaft hat, dass er zeitweise Null wird. Somit weisen die Teilströme Zeitbereiche auf, in denen garantiert ist, dass der zugehörige Teilstrom Null wird. Aufgrund dieser Zeitbereiche kann der Integrator nun derart gesteuert werden, dass dessen Drift auf einen vernachlässigbar geringen Wert minimiert wird, da zum Zeitpunkt wo die Teilströme Null sind in die Messung eingegriffen wird, also die Rogowski-Spulen rückgesetzt werden. Durch diese Maßnahme können auch Gleichströme großer Amplitude (bei einer Widerstandsschweißung bis zu 200 kA) während einer Schweißung, einem Ladeverfahren, mit hoher Genauigkeit unter Verwendung von Rogowski-Spulen und Integratoren ermittelt werden, da das Abdriften der Integratoren vermieden oder reduziert werden kann. Das erfindungsgemäße Verfahren zeichnet sich durch relative Einfachheit und damit verbundene Robustheit aus, weshalb eine Anwendung beispielsweise bei Widerstandsschweißverfahren oder Batterieladeverfahren in idealer Weise möglich ist. Vorteilhaft ist auch, dass mit der erfindungsgemäßen Verwendung bzw. Verschaltung einer herkömmlichen Hardware kostengünstig eine starke Verbesserung der Messgenauigkeit ermöglicht wird. Somit ist es möglich, dass die Rogowski-Spule auch für andere Stromversorgungssysteme, die über einen langen Zeitraum einen Gleichstrom liefern, wie das Laden von Batterien, für die Messung eingesetzt werden kann, da die Rogowski-Spule ständig rückgesetzt werden kann und somit ein Abdriften verhindert wird.

Gemäß einer Variante des erfindungsgemäßen Verfahrens ist vorgesehen, dass eine Summenspannung aus zumindest zwei in zwei gegengleich gepolten Rogowski-Spulen induzierten Teilspannungen gebildet wird und diese in einem Integrator integriert wird. Vorteilhafterweise sind zumindest zwei Rogowski-Spulen zur Messung der durch die Teilströme in zumindest zwei Einzelleitern induzierten Teilspannungen vorgesehen. Erfindungsgemäß wird also durch entsprechende Anordnung der Rogowski-Spulen in den Einzelleitern aufgrund der Teilströme des zu messenden Gleichstroms eine im Wesentlichen mittelwertfreie Summenspannung dem gemeinsamen Integrator zugeführt. Auf diese Weise können beispielsweise die beiden Teilströme eines aus zwei Zweigen bestehenden Gleichrichters gemessen und daraus auf einen zum zu messenden Gleichstrom proportionalen Wert rückgeschlossen werden. Durch die Mittelwertfreiheit der Summenspannung kann die Drift minimiert werden. Ebenso ist keine Rücksetzung des Integrators erforderlich.

Gemäß einem weiteren Merkmal der Erfindung ist vorgesehen, dass eine in einer Rogowksi-Spule induzierte Differenzspannung durch eine aus zumindest zwei entgegengesetzt gerichteten Teilströmen gebildete Stromdifferenz gebildet wird. Praktisch wird dies dadurch erzielt, dass die zumindest zwei Einzelleiter gegengleich durch die Rogowski-Spule geführt werden, so dass die Differenz der Ströme eine Differenzspannung in der Rogowski-Spule induziert. Diese ist praktisch mittelwertfrei, so dass die Drift im Integrator verhindert bzw. minimiert und der Gleichstrom ermittelt werden kann. Ebenso ist dadurch keine Rücksetzung des Integrators erforderlich.

Alternativ oder zusätzlich zu der Maßnahme der Mittelwertfreiheit des dem Integrator zugeführten Signals kann auch jeder Integrator von der Auswerteeinheit regelmäßig während des Fließens des Gleichstroms rückgesetzt werden, wenn der die zumindest eine induzierte Teilspannung hervorrufende zumindest eine Teilstrom im Einzelleiter ≤ Null ist. Es werden also die Phasen bzw. Zeitbereiche der Teilströme in den Einzelleitern ausgenützt, während welcher die Teilströme ≤ Null (sogenannte Nullstromphasen) sind und diese Phasen zum Rücksetzen der Integratoren herangezogen werden.

Gemäß einem Merkmal der Erfindung ist vorgesehen, dass jeder Integrator rückgesetzt wird, wenn das Schaltelement im Einzelleiter des die zu integrierende Teilspannung verursachenden zumindest einen Teilstroms geöffnet ist. Somit wird durch Überwachung des Schaltelements im Einzelleiter erfasst, ob der Teilstrom in diesem Einzelleiter Null ist, und in der Folge der Integrator rückgesetzt.

Das erfindungsgemäße Verfahren wird vorzugsweise in einer Vorrichtung gemäß der nachfolgenden Beschreibung angewandt.

Gelöst wird die erfindungsgemäße Aufgabe auch durch eine oben erwähnte Vorrichtung zum Ermitteln eines in einem Leiter flie-ßenden Gleichstroms, wobei um zumindest einen Einzelleiter zumindest eine Rogowski-Spule zur Induktion einer Teilspannung durch den zumindest einen Teilstrom angeordnet ist, wobei der Einzelleiter durch einen Pfad des Gleichrichters auf der Sekundärseite des Transformators mit Mittelanzapfung gebildet ist, der zumindest eine Integrator zur Integration der zumindest einen Teilspannung ausgebildet ist, und der zumindest eine Integrator mit einer Auswerteeinheit zur Ermittlung des Gleichstroms verbunden ist. Wie bereits oben erwähnt, wird durch die Anordnung der zumindest einen Rogowski-Spule um einen Einzelleiter des Gleichrichters ein Abdriften des der Rogowski-Spule nachgeschalteten Integrators während der Nullstromphasen wirkungsvoll verhindert oder reduziert, da dieser in dieser Phase rückgesetzt werden kann.

Gelöst wird die erfindungsgemäße Aufgabe auch durch eine oben genannte Vorrichtung zum Widerstandsschweißen, wobei um zumindest einen Einzelleiter zumindest eine Rogowski-Spule zur Induktion einer Teilspannung durch den zumindest einen Teilstrom angeordnet ist, wobei der Einzelleiter durch einen Pfad des Gleichrichters auf der Sekundärseite des Transformators mit Mittelanzapfung gebildet ist, der zumindest eine Integrator zur Integration der zumindest einen Teilspannung ausgebildet ist, und der zumindest eine Integrator mit einer Auswerteeinheit zur Ermittlung des Gleichstroms verbunden ist.

Vorteilhafterweise sind zumindest zwei Rogowski-Spulen um zumindest zwei Einzelleiter gegengleich angeordnet, und die Rogowski-Spulen zur Bildung einer mittelwertfreien Summenspannung aus den in den Rogowski-Spulen induzierten Teilspannungen miteinander und mit dem einen Integrator verbunden. Auf diese Weise kann, wie bereits oben erwähnt, eine im Wesentlichen mittelwertfreie Summenspannung dem gemeinsamen Integrator zugeführt werden.

Alternativ dazu kann auch eine Rogowski-Spule um zumindest zwei gegengleich verlaufende Einzelleiter angeordnet sein und die Rogowski-Spule zur Bildung einer mittelwertfreien Differenzspannung aus einer Stromdifferenz der Teilströme mit dem einen Integrator verbunden sein.

Gemäß einem weiteren Merkmal der Erfindung kann jeder Integrator regelmäßig während des Fließens des Gleichstroms rückgesetzt werden, wenn der die zumindest eine induzierte Teilspannung hervorrufende zumindest eine im Einzelleiter fließende Teilstrom ≤ Null ist.

Vorzugsweise ist der zumindest eine Integrator mit jeweils zumindest einem Schaltelement eines Einzelleiters verbunden, so dass der Integrator rücksetzbar ist, wenn das Schaltelement des Einzelleiters geöffnet ist.

Gemäß einem weiteren Merkmal der Erfindung ist vorgesehen, dass die Schaltelemente der Vorrichtung durch Dioden gebildet sind.

Vorteilhafterweise sind zumindest zwei Rogowski-Spulen um jeweils einen Einzelleiter, welcher jeweils einen Teilstrom des zu messenden Gesamtstroms führt, angeordnet.

Dabei kann jede Rogowski-Spule mit je einem Integrator verbunden sein oder alle Rogowski-Spulen mit einem Integrator verbunden sein.

Um zu vermeiden, dass die Messergebnisse durch Fremdmagnetfelder beeinflusst werden, können die Rogowski-Spulen mit einem Abschirmblech versehen sein.

Um den Verlauf des Gleichstroms, insbesondere Schweißstroms, bzw. eines dazu proportionalen Signals aufzuzeichnen, ist der zumindest eine Integrator vorzugsweise mit einem Speicher verbunden. Dabei kann der Speicher direkt in der Auswerteeinheit integriert oder aber auch extern aufgebaut sein. Der externe Speicher kann beispielsweise über ein Netzwerk an die Auswerteeinheit angebunden sein.

Die Vorrichtung wird vorzugsweise zur Ausübung des oben beschriebenen Verfahrens zum Ermitteln eines Gleichstroms eingesetzt.

Die vorliegende Erfindung wird anhand der beigefügten Zeichnung näher erläutert. Darin zeigen:
Fig. 1 ein Schaltbild einer herkömmlichen Methode zur Messung eines Schweißstroms mit Hilfe einer Rogowski-Spule;
Fig. 2 das Prinzip-Schaltbild der Messung eines aus mehreren Teilströmen zusammengesetzten Gleichstroms mit Hilfe einer Rogowski-Spule nach dem Stand der Technik;
Fig. 3 das Prinzip-Schaltbild der erfindungsgemäßen Methode zur Messung eines Gleichstroms mit Hilfe von Rogowski-Spulen;
Fig. 4 die Anwendung des erfindungsgemäßen Verfahrens bei einer Widerstandsschweißvorrichtung;
Fig. 5 die entsprechenden Stromverläufe in Abhängigkeit der Zeit; und
Fig. 6 und 7 zwei alternative Ausführungsformen des erfindungsgemäßen Verfahrens bei der Anwendung an einem Widerstandsschweißgerät.

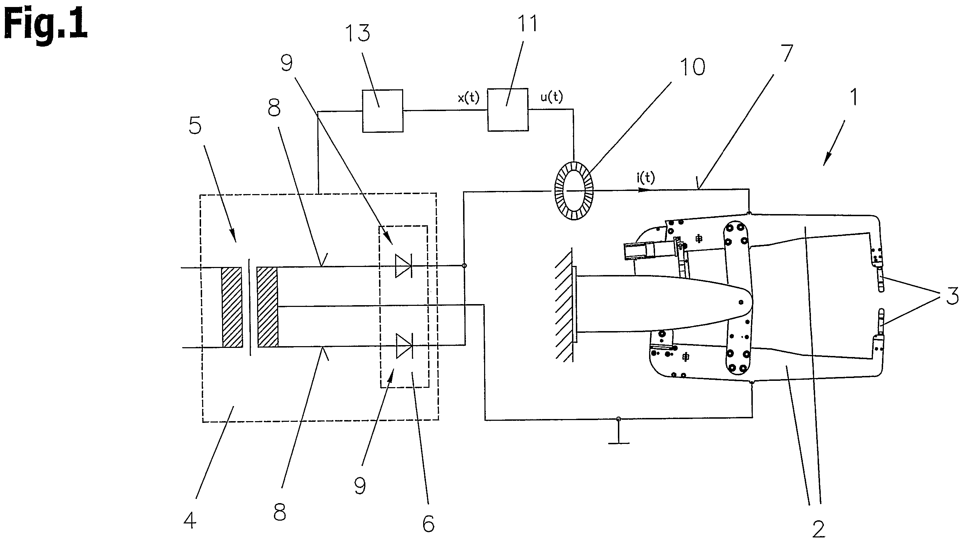

Fig. 1 zeigt schematisch eine Widerstandsschweißvorrichtung 1 mit einer herkömmlichen Messung des Gleichstroms i(t), welcher im Folgenden als Schweißstrom i(t) bezeichnet wird. Die Widerstandsschweißvorrichtung 1 umfasst zwei Schweißarme 2, an welchen die Elektroden 3 befestigt sind. Die zu verschweißenden Werkstücke (nicht dargestellt) werden zwischen den Elektroden 3 angeordnet. Zum Verschweißen der Werkstücke werden die Elektroden 3 gegen die Werkstücke gepresst und mit dem Schweißstrom i(t) beaufschlagt, so dass die Werkstücke aufgrund des Stromflusses aufgeschmolzen und miteinander verbunden werden. Zur Versorgung der Elektroden 3 mit dem Schweißstrom i(t) sind diese mit einer Stromquelle 4 verbunden, welche üblicherweise einen Transformator 5 und einen Gleichrichter 6 umfasst. Auf diese Weise wird der Schweißstrom i(t) in einer üblichen Größenordnung von mehreren kA möglichst verlustarm erzeugt. Zur Messung des Schweißstroms i(t) wird üblicherweise eine Rogowski-Spule 10 um einen Leiter 7, welcher den Schweißstrom i(t) zu den Elektroden 3 führt, angeordnet. Die in der Rogowski-Spule 10 aufgrund des Schweißstroms i(t) induzierte Spannung u(t) wird in einem Integrator 11 integriert und liefert ein dem Schweißstrom i(t) proportionales Signal x(t). Das dem Schweißstrom i(t) proportionale Signal x(t) kann zur Qualitätskontrolle und/oder auch zur Regelung einer Steuereinrichtung 13 bzw. Stromquelle 4 der Widerstandsschweißvorrichtung 1 verwendet werden. Wie bereits oben erwähnt, kommt es durch die Integration der von der Rogowski-Spule 10 aufgenommenen induzierten Spannung u(t) unweigerlich zu einer Drift und zu Fehlmessungen des Schweißstroms i(t). Die Fehler durch die Drift können relativ hoch sein und sind daher zur Sicherung der Qualität der Schweißung unbedingt zu vermeiden. Die Drift kommt dadurch beim Stand der Technik zustande, da über den gesamten Zeitbereich der Schweißung die Messung erfolgt und eine Rücksetzung des Integrators nicht möglich ist, da der gemessene Strom nicht Null wird. Somit kann es bei längeren Schweißungen, wie dies immer öfters der Fall ist, zu einem erheblichen Abweichen kommen. Tritt ein derartiger Fall des Abdriftens ein, so wird aufgrund der Messung für die nachfolgende Messung eine Änderung der Vorgabewerte, also Soll-Werte, vorgenommen, so dass es beispielsweise möglich ist, dass keine sichere Schweißverbindung mehr hergestellt werden kann.

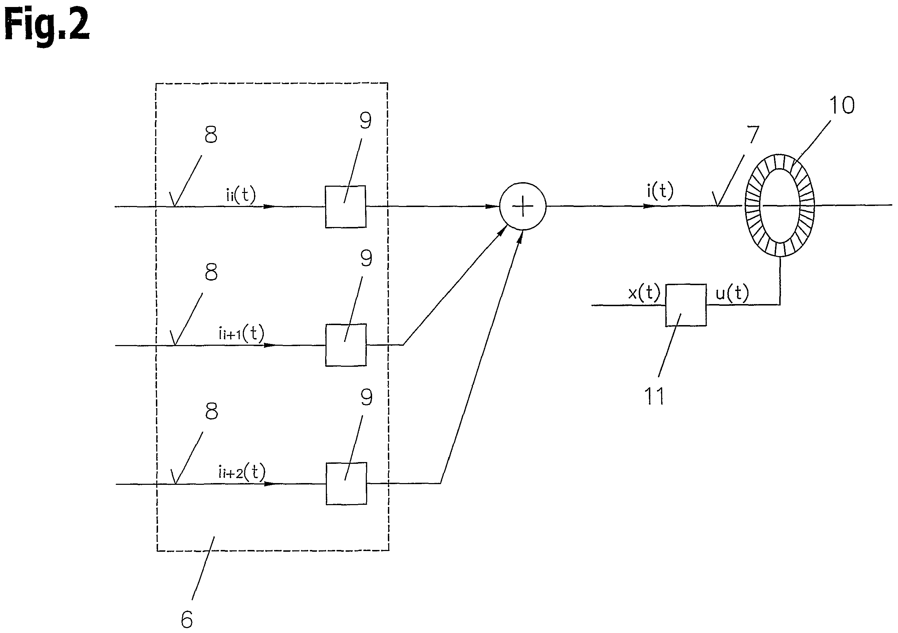

Fig. 2 zeigt ein schematisches Schaltbild zur Veranschaulichung des Verfahrens zum Messen des im Leiter 7 fließenden Schweißstroms i(t) mit Hilfe einer Rogowski-Spule 10. Der zu messende Schweißstrom i(t) wird wie z.B. bei der Widerstandsschweißvorrichtung 1 gemäß Fig. 1 durch mehrere Teilströme iᵢ(t), iᵢ₊₁(t),... eines Gleichrichters 6 zusammengesetzt. Diese Teilströme iᵢ(t), iᵢ₊₁(t),... fließen durch mehrere Einzelleiter 8, welche mit Schaltelementen 9 versehen sind, zu einem Summenpunkt, der im Leiter 7 mündet. Nach dem Stand der Technik wird die Rogowski-Spule 10 zum Messen des Schweißstroms i(t) um den Leiter 7 angeordnet und erfasst die durch den Schweißstrom i(t) induzierte Spannung u(t), welche in einem an der Rogowski-Spule 10 angeschlossenen Integrator 11 integriert wird und ein zu dem zu messenden Schweißstrom i(t) proportionales Signal x(t) liefert. Wie bereits oben erwähnt, verursacht der notwendige Integrator 11 bei der Messung des Schweißstroms i(t) immer ein Abdriften des Signals x(t), da der Integrator 11 nur vor bzw. nach einer Schweißung rückgesetzt werden kann.

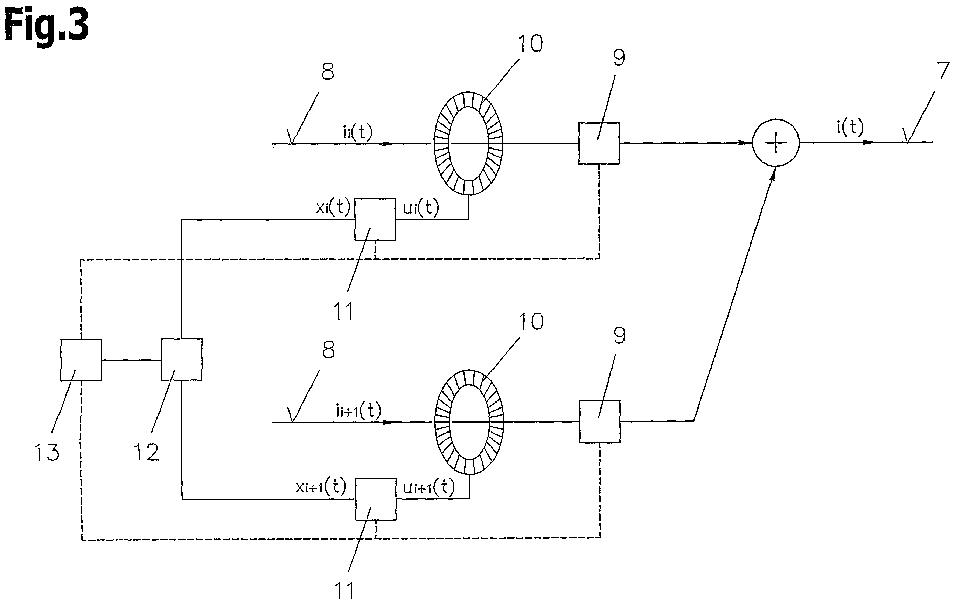

Fig. 3 zeigt ein schematisches Schaltbild des erfindungsgemäßen Verfahrens. In diesem Fall wird berücksichtigt, dass der zu ermittelnde Schweißstrom i(t) durch mehrere Teilströme iᵢ(t), iᵢ₊₁(t),... gebildet wird, wobei zwei Teilströme iᵢ(t) und iᵢ₊₁(t) dargestellt sind. Somit kann durch Messung von zumindest einem der Teilströme iᵢ(t), iᵢ₊₁(t),... durch eine Auswerteeinheit 12 auf den Schweißstrom i(t) während einer Schweißung bzw. während eines Stromflusses (während des Fließens des Schweißstroms i(t)) rückgeschlossen werden bzw. der Schweißstrom i(t) ermittelt werden. Die Auswerteeinheit 12 ermittelt also dabei den Schweißstrom i(t) während der Schweißung basierend auf dem proportionalen Signal x(t) des Integrators 11. Gemäß der Erfindung wird also nicht der relevante Schweißstrom i(t) während der Schweißung direkt gemessen, sondern zumindest einer der Teilströme iᵢ(t), iᵢ₊₁(t), während der Schweißung aus welchem der Schweißstrom i(t) während der Schweißung ermittelt werden kann. Somit wird die in der Rogowski-Spule 10 induzierte Spannung u(t) nicht vom Schweißstrom i(t) erzeugt, sondern entsprechend von den Teilströmen iᵢ(t), iᵢ₊₁(t),... Die Messung eines Teilstroms wie beispielsweise des Teilstroms iᵢ(t) ist im Wesentlichen ausreichend, da eine symmetrische Funktionsweise des Transformators 5 vorausgesetzt werden kann. Durch Messung mehrerer der Teilströme iᵢ(t), iᵢ₊₁(t),... wird die Genauigkeit geringfügig erhöht. Die in den Einzelleitern 8 angeordneten aktiven oder passiven Schaltelemente 9 verursachen durch die Ein- bzw. Ausschaltvorgänge bestimmte Stromverläufe der Teilströme iᵢ(t), iᵢ₊₁(t),... und garantieren auch Zeitbereiche, in denen der zugehörige Teilstrom iᵢ(t), iᵢ₊₁(t),... im Einzelleiter 8 im Wesentlichen Null wird. Das heißt, dass der Teilstrom iᵢ(t) bei geöffnetem Schaltelement 9 (beispielsweise einer Diode im Sperrbetrieb) so gering ist, dass dieser im Wesentlichen als Null bzw. ≤ Null bezeichnet werden kann. Werden nun die Teilströme iᵢ(t), iᵢ₊₁(t),... mit Hilfe von Rogowski-Spulen 10 an diesen Einzelleitern 8 gemessen - also die aufgrund der in den Einzelleitern 8 fließenden Teilströme iᵢ(t), iᵢ₊₁(t),... induzierte Teilspannung uᵢ(t), uᵢ₊₁(t),... dem Integrator 11 zugeführt und integriert - können jene Zeitbereiche, in denen garantiert ist, dass im Einzelleiter 8 kein Stromfluss vorliegt (Nullstromphase), zur Rücksetzung des zugehörigen Integrators 11 genutzt werden. Durch diese Maßnahme können auch Gleichströme mit hoher Amplitude - wie der Schweißstrom i(t) - mit großer Genauigkeit ermittelt werden, da es zu keinem Abdriften der Integratoren 11 kommen kann. Um die Zeitbereiche erfassen zu können, während denen die Teilströme iᵢ(t), iᵢ₊₁(t),... Null sind, können die Schaltelemente 9 in den Einzelleitern 8 überwacht werden. Dies ist durch die strichlierte Linie zwischen den Schaltelementen 9 und den Integratoren 11 veranschaulicht. Ebenso können die Schaltelemente 9 und/oder der Integrator 11 auch mit der Steuervorrichtung 13 verbunden sein. Schlussendlich wird ein den Teilströmen iᵢ(t), iᵢ₊₁(t),... proportionales Signal xᵢ(t), xᵢ₊₁(t),... von den Integratoren 11 an eine Auswerteeinheit 12 geliefert, so dass der Schweißstrom i(t) exakt ermittelbar ist bzw. auf den Schweißstrom i(t) rückgeschlossen werden kann. Die Auswerteeinheit 12 ist bevorzugt auch mit der Steuervorrichtung 13 verbunden, so dass eine Differenz zwischen ermitteltem und vorgegebenem Schweißstrom i(t) ausgeglichen bzw. nachjustiert werden kann.

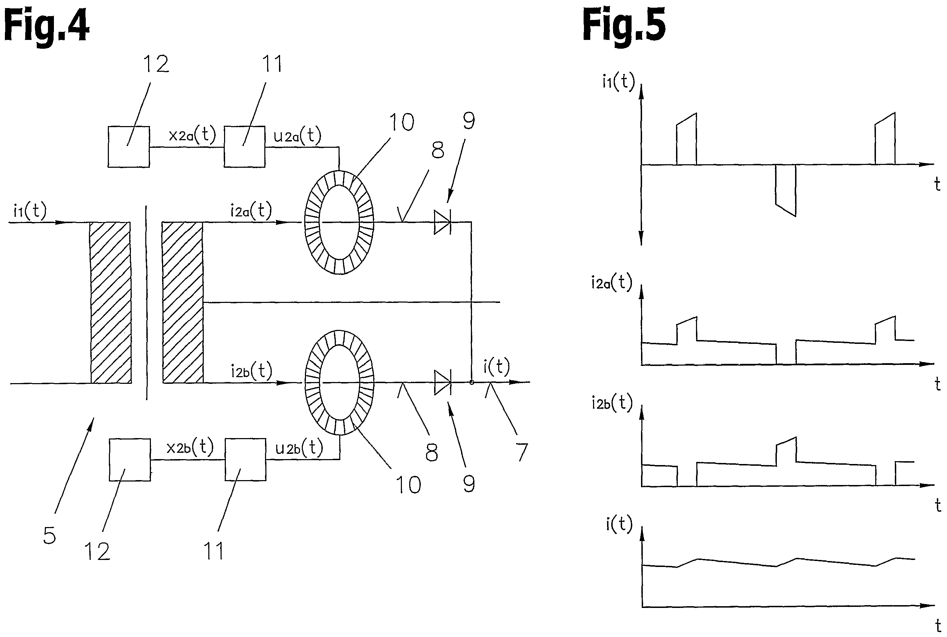

Dieses Prinzip kann nun unterschiedlich eingesetzt werden, wie anhand der folgenden Fig. 4 bis 7 beschrieben.

Fig. 4 zeigt die Anwendung des erfindungsgemäßen Verfahrens bei einer Widerstandsschweißvorrichtung 1, wobei der Einfachheit halber lediglich der Transformator 5 und der Gleichrichter 6 eingezeichnet sind. Der Schweißstrom i(t) fließt während der Schweißung auf einem Leiter 7 zu den Elektroden 3 der Widerstandsschweißvorrichtung 1 (nicht dargestellt). Der Schweißstrom i(t) wird mit Hilfe eines gepulsten Stromes i₁(t), welcher einem Transformator 5 an der Primärseite mit einer Frequenz im Bereich um 1 kHz zugeführt wird, erzeugt. An der Sekundärseite des Transformators 5 mit Mittelanzapfung ist ein aus zwei Dioden als Schaltelemente 9 gebildeter Gleichrichter 6 angeordnet. Dementsprechend sind sekundärseitig zwei Einzelleiter 8 und zwei Teilströme iᵢ(t) und iᵢ₊₁(t) vorhanden, wobei im Folgenden für die Teilströme die Bezeichnung i₂ₐ(t) und i_{2b}(t) statt iᵢ(t) und iᵢ₊₁(t) verwendet wird. Dies soll auch zum Ausdruck bringen, dass die Teilströme im Wesentlichen gleich sind. Der Schweißstrom i(t) ist im Wesentlichen ein reiner Gleichstrom, wie in den Stromverläufen gemäß Fig. 5 veranschaulicht. Diese Teilströme i₂ₐ(t) und i_{2b}(t) weisen nun jeweils Phasen bzw. Zeitbereiche auf, während denen der jeweilige Teilstrom i₂ₐ(t) bzw. i_{2b}(t) Null ist (Nullstromphase). Entsprechend ist die Nullstromphase eines Teilstroms i₂ₐ(t) während des positiven Pulses des gepulsten Stroms i₁(t) und-die Nullstromphase des weiteren Teilstroms i_{2b}(t) während des negativen Pulses des gepulsten Stroms i₁(t). Ebenso entspricht die Nullstromphase beim Teilstrom i₂ₐ(t) der Vollstromphase des Teilstroms i_{2b}(t) und umgekehrt. Werden nun die Rogowski-Spulen 10 erfindungsgemäß um die Einzelleiter 8 an der Sekundärseite des Transformators 5 angeordnet, können die Nullstromphasen, also während denen die Teilströme i₂ₐ(t) und i_{2b}(t) Null sind, zum Rücksetzen der Integratoren 11 verwendet werden. Das Rücksetzen kann softwaremäßig oder hardwaremäßig realisiert werden und erfolgt regelmäßig während der Schweißung. Beispielsweise periodisch gemäß der Frequenz des gepulsten Stromes i₁(t). Durch das Rücksetzen wird die bereits mehrfach angesprochene Drift verhindert. Somit können vom Integrator 11 Signale xₐ(t) und x_{b}(t) geliefert werden, welche proportional zu den Teilströmen i₂ₐ(t) und i_{2b}(t) bzw. induzierten Teilspannungen u₂ₐ(t) und u_{2b}(t) und in der Folge zum Schweißstrom i(t) sind, so dass der Schweißstrom i(t) von der Auswerteeinheit 12 sehr exakt ermittelt werden kann. (Entsprechend den Teilströmen wurde auch die Bezeichnung für die Teilspannungen gewählt.) Dabei kann die Schweißzeit im Gegensatz zum Stand der Technik beliebig lange sein, ohne die Messgenauigkeit des Stromes i(t) zu beeinflussen.

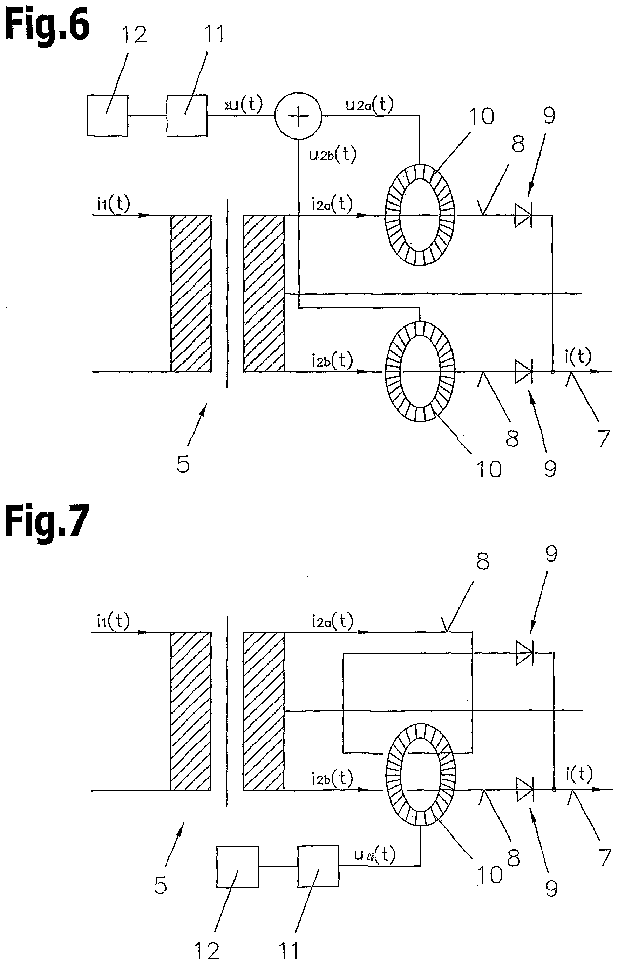

Fig. 6 zeigt eine alternative Ausführungsform der Erfindung, bei der zwei Rogowski-Spulen 10 gegengleich um jeweils einen Einzelleiter 8 - welche entsprechend die Teilspannungen u₂ₐ(t), u_{2b}(t) induzieren - an der Sekundärseite des Transformators 5 angeordnet sind und mit einem gemeinsamen Integrator 11 verbunden sind. Das heißt, dass die Rogowski-Spulen 10 gegengleich gepolt in Serie geschaltet sind. Auf diese Weise wird eine im Wesentlichen mittelwertfreie, gemeinsame Summenspannung ∑u(t) aus den induzierten Teilspannungen u₂ₐ(t) und u_{2b}(t) von den beiden Rogowski-Spulen 10 geliefert, welche dem Integrator 11 zugeführt und integriert wird. Durch die Mittelwertfreiheit der Summenspannung ∑u(t) kann die Drift des Integrators 11 vermieden bzw. erheblich reduziert werden.

Bei der Variante gemäß Fig. 7 wird nur eine Rogowski-Spule 10 verwendet, welche die Einzelleiter 8 der beiden Teilströme i₂ₐ(t) und i_{2b}(t) so umfasst, dass ein Einzelleiter 8, welcher den Teilstrom i₂ₐ(t) führt, entgegengesetzt zum Einzelleiter 8, der den Teilstrom i_{2b}(t) führt, orientiert ist. Dadurch wird in der Rogowski-Spule 10 eine Differenzspannung u_{Δi}(t) induziert. Diese Differenzspannung u_{Δi}(t) wird aus der Stromdifferenz Δi(t) zwischen den Teilströmen i₂ₐ(t) und i_{2b}(t) gebildet. Durch diese Anordnung ist die Differenzspannung u_{Δi}(t) praktisch mittelwertsfrei, wodurch eine Drift des Integrators 11 nicht auftreten kann.

Zu den Beschreibungen zu den Fig. 6 und 7 sei ergänzend erwähnt, dass dabei der Integrator 11 nicht zurückgesetzt werden muss, da dieser ja eine mittelwertfreie Spannung (im Gegensatz zu Fig. 4) verarbeitet. Diese Mittelwertfreiheit ist erst durch die Verwendung eines Transformators gegeben, was einen markanten Unterschied zum Stand der Technik darstellt. Das vom Integrator 11 gelieferte Signal kann somit mit einer BIBO-stabilen Übertragungsfunktion - welche einer näherungsweisen Integration entspricht - in der Auswerteeinheit 12 ausgewertet und der Schweißstrom i(t) während der Schweißung exakt ermittelt werden.

Allgemein ist zu den beschriebenen Figuren noch zu erwähnen, dass die erfindungsgemäße Anordnung der Rogowski-Spule 10 um den Einzelleiter 8 von Bedeutung ist. Der Einzelleiter 8 ist dabei bevorzugt durch einen Pfad des Gleichrichters 6 auf der Sekundärseite des Transformators 5 gebildet. Der Gleichrichter 6 ist dabei beispielsweise Bestandteil von zumindest einer Komponente zur Durchführung einer Schweißung, eines Ladevorgangs einer Batterie oder einer Umwandlung von Gleichstrom in Wechselstrom. Davon ist unabhängig, ob das Schaltelement 9 vor oder nach der Rogowski-Spule 10 angeordnet ist.

Ebenso kann der Integrator 11 allgemein als ein technisches System gesehen werden, das auf ein beliebiges Eingangssignal - wie der induzierten Spannung u(t) - mit einem Ausgangssignal x(t) antwortet, welches dem zeitlichen Integral des Eingangssignals proportional ist. Realisiert kann der Integrator 11 durch verschiedenste analoge Schaltungen, aber auch in über Analog-Digital-Wandlern bzw. Digital-Analog-Wandlern angebundenen digitalen Rechnersystemen werden. Derartige Systeme werden entsprechend als Integratoren 11 bezeichnet. Die analoge Integratorschaltung kann beispielsweise aus aktiven Teilen (Operationsverstärker, Transistoren etc.) wie auch aus passiven Teilen (ohmsche Widerstände, Induktivitäten, Kapazitäten etc.) bestehen. Das digitale Rechnersystem zur Realisierung des Integrators 11 kann beispielsweise ein digitaler Signalprozessor, ein Mikroprozessor oder auch ein herkömmlicher PC sein.

Ein technisches System, das auf bestimmte Signalklassen (wie beispielsweise die induzierte Spannung u(t)) mit einem Ausgangssignal x(t) antwortet, welches dem zeitlichen Integral des Eingangssignal proportional ist, wird als näherungsweiser Integrator bezeichnet. Derartige Systeme können im Gegensatz zu Integratoren 11 BIBO-stabil realisiert werden.

Obgleich in der obigen Beschreibung hauptsächlich auf Widerstandsschweißverfahren eingegangen wird, kann die gegenständliche Erfindung auch zur Messung anderer hoher Gleichströme, wie sie beispielsweise bei Batterieladegeräten auftreten, eingesetzt werden.

## Patentansprüche

1. Verfahren zum Ermitteln eines in einem Leiter (7) fließenden Gleichstroms (i(t)) mit einer Amplitude größer 500 A, welcher Gleichstrom (i(t)) durch mehrere, in Einzelleitern (8) mit Schaltelementen (9) fließende, zeitabhängige Teilströme (iᵢ(t)) zusammengesetzt wird, **dadurch gekennzeichnet, dass** zumindest eine induzierte Teilspannung (uᵢ(t)) durch den zumindest in einem Einzelleiter (8) fließenden Teilstrom (iᵢ(t)) durch Anordnung zumindest einer Rogowski-Spule (10) um zumindest einen Einzelleiter (8) erzeugt wird, wobei der Einzelleiter (8) durch einen Pfad eines Gleichrichters (6) auf einer Sekundärseite eines Transformators (5) mit Mittelanzapfung gebildet wird, und diese induzierte Teilspannung (uᵢ(t)) in zumindest einem Integrator (11) integriert wird und mit einer mit dem zumindest einen Integrator (11) verbundenen Auswerteeinheit (12) der Gleichstrom (i(t)) ermittelt wird.

2. Verfahren nach Anspruch 1, **dadurch gekennzeichnet, dass** eine Summenspannung (∑u(t)) aus zumindest zwei in zwei gegengleich gepolten Rogowski-Spulen (10) induzierten Teilspannungen (uᵢ(t)) gebildet wird und diese in einem Integrator (11) integriert wird.

3. Verfahren nach Anspruch 1, **dadurch gekennzeichnet, dass** eine in einer Rogowski-Spule (10) induzierte Differenzspannung (u_{Δi}(t)) durch eine aus zumindest zwei entgegengesetzt gerichteten Teilströmen (iᵢ(t), iᵢ₊₁(t)) gebildete Stromdifferenz (Δi(t)) gebildet wird.

4. Verfahren nach Anspruch 1, **dadurch gekennzeichnet, dass** jeder Integrator (11) von der Auswerteeinheit (12) regelmäßig während des Fließens des Gleichstroms (i(t)) rückgesetzt wird, wenn der die zumindest eine induzierte Teilspannung (uᵢ(t)) hervorrufende zumindest eine Teilstrom (iᵢ(t)) im Einzelleiter (8) ≤ Null ist.

5. Verfahren nach Anspruch 4, **dadurch gekennzeichnet, dass** jeder Integrator (11) rückgesetzt wird, wenn das Schaltelement (9) im Einzelleiter (8) des die zu integrierende Teilspannung (uᵢ(t)) verursachenden zumindest einen Teilstroms (iᵢ(t)) geöffnet ist.

6. Verfahren nach einem der Ansprüche 1 bis 5, **dadurch gekennzeichnet, dass** dieses in einer Vorrichtung gemäß den Ansprüchen 7 bis 19 angewandt wird.

7. Vorrichtung zum Ermitteln eines in einem Leiter (7) fließenden Gleichstroms (i(t)) mit einer Amplitude größer 500 A, welcher Gleichstrom (i(t)) durch mehrere, in Einzelleitern (8) mit Schaltelementen (9) fließende, zeitabhängige Teilströme (iᵢ(t)) zusammengesetzt ist, **dadurch gekennzeichnet, dass** um zumindest einen Einzelleiter (8) zumindest eine Rogowski-Spule (10) zur Induktion einer Teilspannung (uᵢ(t)) durch den zumindest einen Teilstrom (iᵢ(t)) angeordnet ist, wobei der Einzelleiter (8) durch einen Pfad des Gleichrichters (6) auf der Sekundärseite eines Transformators (5) mit Mittelanzapfung gebildet ist, der zumindest eine Integrator (11) zur Integration der zumindest einen Teilspannung (uᵢ(t)) ausgebildet ist, und der zumindest eine Integrator (11) mit einer Auswerteeinheit (12) zur Ermittlung des Gleichstroms (i(t)) verbunden ist.

8. Vorrichtung (1) nach Anspruch 7, **dadurch gekennzeichnet, dass** die zumindest eine Rogowski-Spule (10) um den Einzelleiter (8) eines Gleichrichters (6) mit Schaltelementen (9) einer Stromquelle (4) einer Widerstandsschweißvorrichtung (1) zur Ermittlung des Schweißstroms angeordnet ist.

9. Vorrichtung nach Anspruch 7 oder 8, **dadurch gekennzeichnet, dass** zumindest zwei Rogowski-Spulen (10) um zumindest zwei Einzelleiter (8) gegengleich angeordnet sind, und die Rogowski-Spulen (10) zur Bildung einer mittelwertfreien Summenspannung (∑u(t)) aus den in den Rogowski-Spulen (10) induzierten Teilspannungen (uᵢ(t)) miteinander und mit dem einen Integrator (11) verbunden sind.

10. Vorrichtung nach Anspruch 7 oder 8, **dadurch gekennzeichnet, dass** eine Rogowski-Spule (10) um zumindest zwei gegengleich verlaufende Einzelleiter (8) angeordnet ist und die Rogowski-Spule (10) zur Bildung einer mittelwertfreien Differenzspannung (u_{Δi}(t)) aus einer Stromdifferenz (Δi(t)) der Teilströme (iᵢ(t)) mit dem einen Integrator (11) verbunden ist.

11. Vorrichtung nach Anspruch 7 oder 8, **dadurch gekennzeichnet, dass** jeder Integrator (11) regelmäßig während des Fließens des Gleichstroms (i(t)) rücksetzbar ist, wenn der die zumindest eine induzierte Teilspannung (uᵢ(t)) hervorrufende zumindest eine im Einzelleiter (8) fließende Teilstrom (iᵢ(t)) ≤ Null ist.

12. Vorrichtung nach Anspruch 11, **dadurch gekennzeichnet, dass** der zumindest eine Integrator (11) mit jeweils zumindest einem Schaltelement (9) eines Einzelleiters (8) verbunden ist, so dass der Integrator (11) rücksetzbar ist, wenn das Schaltelement (9) des Einzelleiters (8) geöffnet ist.

13. Vorrichtung nach einem der Ansprüche 7 bis 12, **dadurch gekennzeichnet, dass** die Schaltelemente (9) durch Dioden gebildet sind.

14. Vorrichtung nach einem der Ansprüche 7 bis 9 oder 11 bis 13, **dadurch gekennzeichnet, dass** zumindest zwei Rogowski-Spulen (10) um jeweils einen Einzelleiter (8) angeordnet sind.

15. Vorrichtung nach Anspruch 14, **dadurch gekennzeichnet, dass** jede Rogowski-Spule (10) mit je einem Integrator (11) verbunden ist.

16. Vorrichtung nach Anspruch 14, **dadurch gekennzeichnet, dass** alle Rogowski-Spulen (10) mit einem Integrator (11) verbunden sind.

17. Vorrichtung nach einem der Ansprüche 7 bis 16, **dadurch gekennzeichnet, dass** jede Rogowski-Spule (10) mit einem Abschirmblech versehen ist.

18. Vorrichtung nach einem der Ansprüche 7 bis 17, **dadurch gekennzeichnet, dass** der zumindest eine Integrator (11) mit einem Speicher (14) verbunden ist.

19. Vorrichtung nach einem der Ansprüche 7 bis 18, **dadurch gekennzeichnet, dass** die Vorrichtung zur Ausübung des Verfahrens gemäß den Ansprüchen 1 bis 5 eingesetzt ist.

## Claims

1. A method for determining a direct current (i(t)) flowing in a conductor (7) and having an amplitude greater than 500 A, which direct current (i(t)) is composed of a number of time-dependent partial currents (iᵢ(t)) flowing in individual conductors (8) having switching elements (9), **characterized in that** at least one induced partial voltage (uᵢ(t)) is created by the partial current (iᵢ(t)) flowing in at least one individual conductor (8) by arranging at least one Rogowski coil (10) around at least one individual conductor (8), wherein the individual conductor (8) is formed by a path of a rectifier (6) on a secondary side of a transformer (5) with central tapping, and this induced partial voltage (uᵢ(t)) is integrated in at least one integrator (11) and the direct current (i(t)) is determined with an evaluation unit (12) connected to the at least one integrator (11).

2. The method according to claim 1, **characterized in that** a sum voltage (∑u(t)) is formed of at least two partial voltages (uᵢ(t)) induced in two Rogowski coils (10) wired equally opposed, and this is integrated in an integrator (11).

3. The method according to claim 1, **characterized in that** a differential voltage (u_{Δi}(t)) induced in one Rogowski coil (10) is formed by a current difference (Δi(t)) formed by at least two partial currents (iᵢ(t), iᵢ₊₁(t)) oriented opposed.

4. The method according to claim 1, **characterized in that** each integrator (11) of the evaluation unit (12) is periodically reset during the flowing of direct current (i(t)), when the at least one partial current (iᵢ(t)) in the individual conductor (8) causing the at least one induced partial voltage (uᵢ(t)) is ≤ zero.

5. The method according to claim 4, **characterized in that** each integrator (11) is reset, when the switching element (9) in the individual conductor (8) of the at least one partial current (iᵢ(t)) causing the partial voltage (uᵢ(t)) to be integrated, is opened.

6. The method according to one of claims 1 to 5, **characterized in that** this is applied in a device according to claims 7 to 19.

7. A device for determining a direct current (i(t)) flowing in a conductor (7) and having an amplitude greater than 500 A, which direct current (i(t)) is composed of a number of time-dependent partial currents (iᵢ(t)) flowing in individual conductors (8) having switching elements (9), **characterized in that** at least one Rogowski coil (10) is arranged around at least one individual conductor (8) for the induction of a partial voltage (uᵢ(t)) by the at least one partial current (iᵢ(t)), wherein the individual conductor (8) is formed by a path of a rectifier (6) on the secondary side of a transformer (5) with central tapping, the at least one integrator (11) is designed for integration of the at least one partial voltage (uᵢ(t)), and the at least one integrator (11) is connected to an evaluation unit (12) for determining the direct current (i(t).

8. The device (1) according to claim 7, **characterized in that** the at least one Rogowski coil (10) is arranged around the individual conductor (8) of a rectifier (6) with switching elements (9) of a current source (4) of a resistance welding device (1) for determining the welding current.

9. The device according to claim 7 or 8, **characterized in that** at least two Rogowski coils (10) are arranged around at least two individual conductors (8) equally opposed, and the Rogowski coils (10) are connected to each other and to the one integrator (11) for taking a mean value free sum voltage (∑u(t)) from the partial voltages (uᵢ(t)) induced in the Rogowski coils (10).

10. The device according to claim 7 or 8, **characterized in that** one Rogowski coil (10) is arranged around at least two individual conductors (8) running equally opposed, and the Rogowski coil (10) is connected to the one integrator (11) for taking a mean value free differential voltage (u_{Δi}(t)) of a current difference (Δi(t)) of the partial currents (iᵢ(t)).

11. The device according to claim 7 or 8, **characterized in that** each integrator (11) is periodically reset during the flowing of direct current (i(t)), when the at least one partial current (iᵢ(t)) flowing in the individual conductor (8) causing the at least one induced partial voltage (uᵢ(t)) is ≤ zero.

12. The device according to claim 11, **characterized in that** the at least one integrator (11) is respectively connected to at least one switching element (9) of an individual conductor (8) so that the integrator (11) can be reset, when the switching element (9) of the individual conductor (8) is opened.

13. The device according to one of claims 7 to 12, **characterized in that** the switching elements (9) are formed by diodes.

14. The device according to one of claims 7 to 9 or 11 to 13, **characterized in that** at least two Rogowski coils (10) are arranged around one individual conductor (8) each.

15. The device according to claim 14, **characterized in that** each Rogowski coil (10) is connected to an integrator (11) each.

16. The device according to claim 14, **characterized in that** all Rogowski coils (10) are connected to an integrator (11).

17. The device according to one of claims 7 to 16, **characterized in that** each Rogowski coil (10) is provided with a shielding plate.

18. The device according to one of claims 7 to 17, **characterized in that** the at least one integrator (11) is connected to a memory (14).

19. The device according to one of claims 7 to 18, **characterized in that** the device is used for practicing the method according to claims 1 to 5.

## Revendications

1. Procédé destiné à déterminer un courant continu (i(t)) d'une amplitude supérieure à 500 A parcourant un conducteur (7), lequel courant continu (i(t)) est composé de plusieurs courants partiels (iᵢ(t)) dépendants du temps qui parcourent des conducteurs individuels (8) pourvus d'éléments de commutation (9), **caractérisé en ce qu'**au moins une tension partielle (u_{¡}(t)) induite est produite par le courant partiel (iᵢ(t)) parcourant au moins un conducteur individuel (8) par la disposition d'au moins une bobine de Rogowski (10) autour d'au moins un conducteur individuel (8), le conducteur individuel (8) étant formé par un chemin d'un redresseur (6) sur un côté secondaire d'un transformateur (5) avec prise médiane, et cette tension partielle (uᵢ(t)) induite étant intégrée dans au moins un intégrateur (11), et le courant continu (i(t)) étant déterminé avec une unité d'évaluation (12) raccordée à l'intégrateur (11) au moins au nombre de un.

2. Procédé selon la revendication 1, **caractérisé en ce qu'**une somme des tensions (∑u(t)) est formée d'au moins deux tensions partielles (uᵢ(t)) induites dans deux bobines de Rogowski (10) ayant une polarisation diamétralement opposée, et **en ce que** cette somme est intégrée dans un intégrateur (11).

3. Procédé selon la revendication 1, **caractérisé en ce qu'**une tension différentielle (u_{Δi}(t)) induite dans une bobine de Rogowski (10) est formée par une différence des tensions (Δi(t)) formée à partir d'au moins deux courants partiels (iᵢ(t), iᵢ₊₁ (t)) de directions opposées.

4. Procédé selon la revendication 1, **caractérisé en ce que** chaque intégrateur (11) est remis à zéro par l'unité d'évaluation (12) régulièrement pendant l'écoulement du courant continu (i(t)) quand le courant partiel (iᵢ(t)) au moins au nombre de un suscitant la tension partielle (uᵢ(t)) induite au moins au nombre de un est ≤ zéro dans le conducteur individuel (8).

5. Procédé selon la revendication 4, **caractérisé en ce que** chaque intégrateur (11) est remis à zéro quand l'élément de commutation (9) dans le conducteur individuel (8) du courant partiel (iᵢ(t)) au moins au nombre de un causant la tension partielle (uᵢ(t)) à intégrer est ouvert.

6. Procédé selon l'une des revendications 1 à 5, **caractérisé en ce que** celui-ci est utilisé dans un dispositif selon les revendications 7 à 19.

7. Dispositif destiné à déterminer un courant continu (i(t)) d'une amplitude supérieure à 500 A parcourant un conducteur (7), lequel courant continu (i(t)) est composé de plusieurs courants partiels (iᵢ(t)) dépendants du temps qui parcourent des conducteurs individuels (8) pourvus d'éléments de commutation (9), **caractérisé en ce que**, pour l'induction d'une tension partielle (uᵢ(t)) par le courant partiel (iᵢ(t)) au moins au nombre de un, au moins une bobine de Rogowski (10) est disposée autour d'au moins un conducteur individuel (8), le conducteur individuel (8) étant formé par un chemin du redresseur (6) sur le côté secondaire d'un transformateur (5) avec prise médiane, l'intégrateur (11) au moins au nombre de un étant formé pour l'intégration de la tension partielle (uᵢ(t)) au moins au nombre de un, et l'intégrateur (11) au moins au nombre de un étant raccordé à une unité d'évaluation (12) pour la détermination du courant continu (i(t)).

8. Dispositif selon la revendication 7, **caractérisé en ce que** la bobine de Rogowski (10) au moins au nombre de un est disposée autour du conducteur individuel (8) d'un redresseur (6) pourvu d'éléments de commutation (9) d'une source de courant (4) d'un dispositif de soudage par résistance (1) pour la détermination du courant de soudage.

9. Dispositif selon la revendication 7 ou 8, **caractérisé en ce qu'**au moins deux bobines de Rogowski (10) sont disposées de façon diamétralement opposée autour d'au moins deux conducteurs individuels (8), et les bobines de Rogowski (10) sont raccordées entre elles et avec l'intégrateur (11) pour la formation d'une somme des tensions (∑u(t)) sans valeur moyenne à partir des tensions partielles (uᵢ(t)) induites dans les bobines de Rogowski (10).

10. Dispositif selon la revendication 7 ou 8, **caractérisé en ce qu'**une bobine de Rogowski (10) est disposée autour d'au moins deux conducteurs individuels (8) diamétralement opposés, et la bobine de Rogowski (10) est raccordée à l'intégrateur (11) pour la formation d'une tension différentielle (u_{Δi}(t)) sans valeur moyenne à partir d'une différence des tensions (Δi(t)) des courants partiels (iᵢ(t)).

11. Dispositif selon la revendication 7 ou 8, **caractérisé en ce que** chaque intégrateur (11) peut être remis à zéro régulièrement pendant l'écoulement du courant continu (i(t)) quand le courant partiel (iᵢ(t)) au moins au nombre de un parcourant le conducteur individuel (8) et suscitant la tension partielle (uᵢ(t)) induite au moins au nombre de un est ≤ zéro.

12. Dispositif selon la revendication 11, **caractérisé en ce que** l'intégrateur (11) au moins au nombre de un est raccordé à respectivement au moins un élément de commutation (9) d'un conducteur individuel (8) de telle sorte que l'intégrateur (11) peut être remis à zéro quand l'élément de commutation (9) du conducteur individuel (8) est ouvert.

13. Dispositif selon l'une des revendications 7 à 12, **caractérisé en ce que** les éléments de commutation (9) sont formés par des diodes.

14. Dispositif selon l'une des revendications 7 à 9 ou 11 à 13, **caractérisé en ce qu'**au moins deux bobines de Rogowski (10) sont disposées autour de respectivement un conducteur individuel (8).

15. Dispositif selon la revendication 14, **caractérisé en ce que** chaque bobine de Rogowski (10) est raccordée à respectivement un intégrateur (11).

16. Dispositif selon la revendication 14, **caractérisé en ce que** toutes les bobines de Rogowski (10) sont raccordées à un intégrateur (11).

17. Dispositif selon l'une des revendications 7 à 16, **caractérisé en ce que** chaque bobine de Rogowski (10) est munie d'une tôle de blindage.

18. Dispositif selon l'une des revendications 7 à 17, **caractérisé en ce que** l'intégrateur (11) au moins au nombre de un est raccordé à une mémoire (14).

19. Dispositif selon l'une des revendications 7 à 18, **caractérisé en ce que** le dispositif est utilisé pour la réalisation du procédé selon les revendications 1 à 5.
